# EUROPEAN PATENT SPECIFICATION

(11) **EP 1 182 918 B1**
(45) Date of publication and mention of the grant of the patent: **24.01.2007**
(21) Application number: 01203055.7
(22) Date of filing: 10.08.2001
(51) Int. Cl.: H05K 9/00, H05K 7/14

(54) **Printed circuit board guide, and method for its production**
Führungselement für Leiterplatte und zugehöriges Herstellungsverfahren
Guide pour plaquette de circuit imprimé et méthode de sa fabrication

(30) Priority: 17.08.2000 NL 1015952
(43) Date of publication of application: 27.02.2002
(73) Proprietor: TELEFONAKTIEBOLAGET LM ERICSSON (publ), 164 83 Stockholm (SE)
(72) Inventor: te Riet, Johan, 7552 SL Hengelo (NL)
(74) Representative: van der Arend, Adrianus G.A.

(56) References cited:
- WO-A-98/21782
- FR-A- 2 596 232
- US-A- 3 673 669
- US-A- 5 879 167

## Description

The invention relates to a printed circuit board guide according to the preamble of claim 1.

A printed circuit board guide of this type is known in practice in various embodiments.

According to one embodiment, the guide consists of a plastic rail, having a groove in its longitudinal direction for guiding a printed circuit board, and having integrally formed fingers which can rest resiliently against both sides of the printed circuit board. Such a guide is a moulded piece, which is difficult and expensive to manufacture. Furthermore, the fingers are relatively thin in the region of their bend lines, with the result that the fingers can easily break, and are not sufficiently rigid when, as is generally the intention, they are fitted close to a motherboard with a connector into which it must be possible to slide the printed circuit board accurately. Another drawback is that such guides are relatively long, with the result that the space on the printed circuit board for placing components on it is limited.

Another embodiment of the known printed circuit board guide is composed of a relatively thin, resilient sheet metal, from which strips facing each other are formed, between which strips there is a space for guiding a printed circuit board. The strips face each other like teeth, with the result that sliding a printed circuit board between them is not a smooth operation, and the surfaces of the printed circuit board are damaged. Furthermore, the strips do not provide resilient retention of the printed circuit board, but only provide play, which makes accurate positioning of the printed circuit board in a connector of a motherboard difficult.

US 3,673,669 discloses a guide formed by two resilient metal members of which a plurality of tabs and associated openings are formed. The both metal members are reversely oriented in a superposed manner with the tabs of the first member passing through the corresponding openings in the second member, therefore forming a plurality of pairs of opposing tabs. Between each pair of opposing tabs, a printed circuit board can be inserted and compressively restrained.

The object of the invention is to eliminate the abovementioned drawbacks.

To that end, the invention provides a printed circuit board guide according to claim 1.

In addition, the invention provides a method for producing such a printed circuit board guide according to claim 4. In this way, the printed circuit board guide can be produced simply and cheaply.

Other features and advantages of the invention will become clear from the following explanation in conjunction with the appended drawings, in which:
Fig. 1 shows in perspective a printed circuit board guide according to the invention, with several locations for guiding a printed circuit board;
Fig. 2 shows a front view of the guide of Fig. 1;
Fig. 3 shows a view from above of the guide of Fig. 1;
Fig. 4 shows a left side view of the guide of Fig. 1;
Fig. 5 shows a rear view of the guide of Fig. 1; and
Fig. 6 shows in perspective a part of a construction in which the guide of Fig. 1 is used.

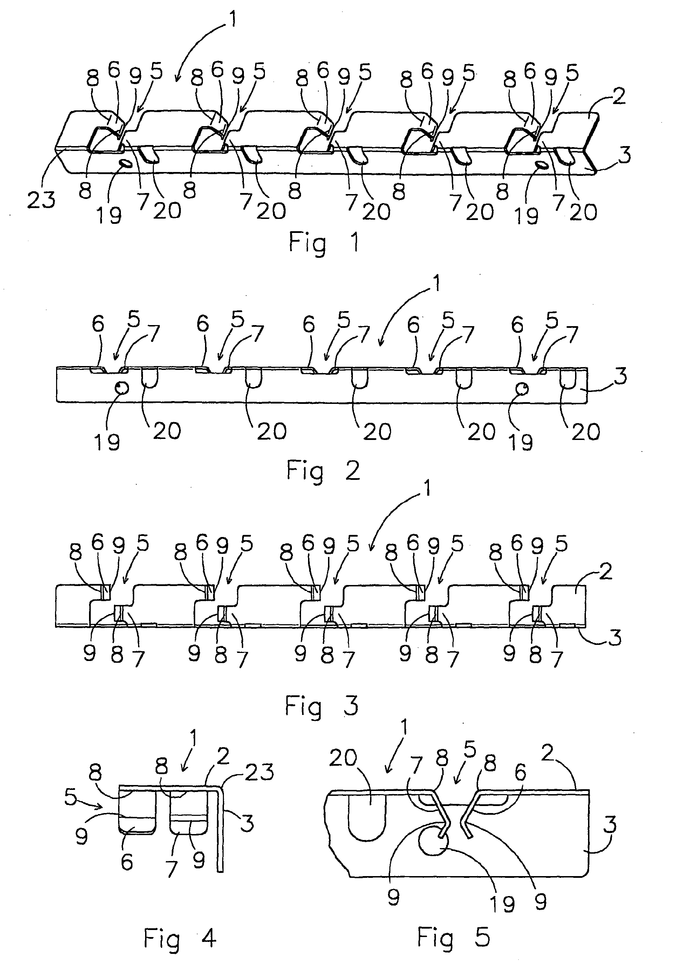

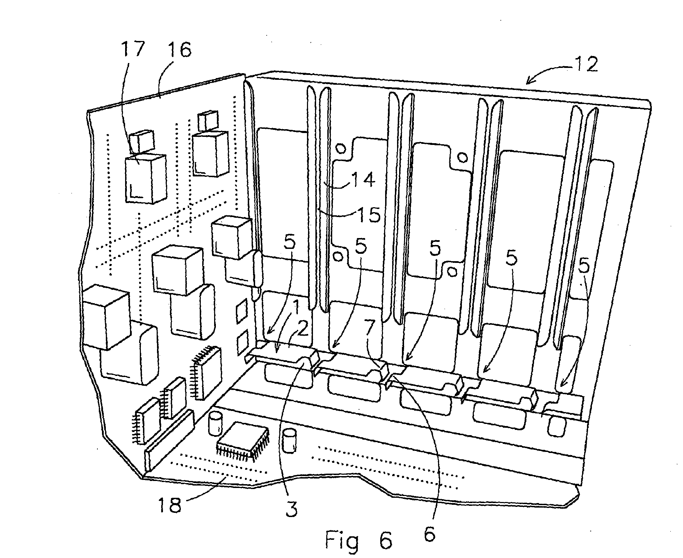

The printed circuit board guide 1 shown in Fig. 1 is made of resilient material and is in the form of an angle section with squared sides 2, 3. Pairs 5 of fingers 6, 7 are formed at five locations in the side 2, in the longitudinal direction of the guide 1. The fingers 6, 7 are bent over bend lines 8, which are situated perpendicular to the side 3, through an angle which is less than 90°. At a distance from the side 2, the fingers 6, 7 are bent back over bend lines 9, which run parallel to the bend lines 8, until they are under the remainder of the finger 6, 7 concerned. The distance between the fingers 6, 7 at the level of the bend lines 9, and measured perpendicular to a printed circuit board (16 in Fig. 6) to be slid between the fingers 6, 7 of a pair 5, is less than the thickness of the printed circuit board. The space between the fingers 6, 7 of each pair 5 is called guide space here.

Since the guide 1 is made of resilient material, it is even permissible for the distance between the fingers at the level of the bend lines 9 to be zero or negative. The only condition is that the distance between the bend lines 8 of the fingers 6, 7 of a pair 5 must be greater than the thickness of the printed circuit board.

Fig. 6 shows a construction 12 on which a number of guide rails 14, each with a guide groove 15 are fixed to each other, parallel to and at a distance from each other. Each guide rail 14 is capable of guiding in its groove 15 an edge part of a printed circuit board 16 on which electronic components, such as 17, are fitted. A further guide rail 14 (not shown) is fixed for the opposite edge part of each printed circuit board 16, the guide groove 15 of the latter guide rail facing the earlier mentioned guide groove 15.

A mother printed circuit board 18, hereinafter called motherboard, is fixed on the construction 12 in such a way that the printed circuit board 16 can be slid perpendicular to the motherboard 18, and an end of the printed circuit board 16 which is to be slid deepest into the construction 12 can be plugged into one or more connectors (not shown) of the motherboard 18.

Two printed circuit board guides 1 according to the invention lying opposite each other (one of which is shown in Fig. 6) are fitted between the ends of the guide rails 14 and the motherboard 18, parallel to the motherboard 18. The printed circuit board guide 1 can be fixed on the construction 12 in various ways, such as by spot welding or by means of screws through holes 19 in the side 3 of the printed circuit board guide 1.

The groove 15 of each guide rail 14 opens out opposite the guide space between the fingers 6, 7 of a corresponding pair 5.

Through the resilient action of the fingers 6, 7, a front edge of a printed circuit board 16 which is being slid by way of a pair of opposite guide rails 14 into the construction 12 is guided accurately and reliably to a certain location of the motherboard 18, in particular into a connector of said motherboard.

The strength of the resilient action of the fingers 6, 7 of the printed circuit board guide 1 can easily be predetermined and subsequently maintained by a suitable selection of the starting material of the guide 1.

The printed circuit board guide 1 is simple and cheap to produce. For the production, the starting material can be a flat strip in which alignment holes 20 can be punched in the later side 3, and in which recesses can be punched in the later side 2, for releasing the fingers 6, 7. The still flat fingers 6, 7 can then be bent over the bend lines 8, 9. Finally, the strip can be bent over an angle line 23 running in its longitudinal direction, in order to form the squared sides 2, 3 of the printed circuit board guide 1. This method of production can even be carried out in a continuous process, in order to obtain printed circuit board guides with many pairs 5 of fingers 6, 7, which can subsequently be cut to the desired length.

Although the printed circuit board 1 has been explained above in conjunction with the appended drawings as being designed with more than one pair 5 of fingers 6, 7, the printed circuit board guide according to the invention also comprises an embodiment with a single pair 5 of fingers 6, 7.

Furthermore, the invention is not limited to the use of pairs 5 of fingers 6, 7, but a group of more than two fingers 6, 7 can be used instead of each pair.

The fingers 6, 7 of a pair 5 or group need not necessarily be bent in the same direction of the side 2.

Moreover, the printed circuit board guide according to the invention can also be in a form other than the angle section of the printed circuit board guide 1 illustrated.

Spring steel can be used as the material for the printed circuit board guide according to the invention. If the guide is then earthed and the fingers press against earth conductors of the printed circuit board, an excellent electromagnetic shielding can be obtained in this way. The relatively high pressure which the spring steel can exert between the contacts (bend lines 9) of the printed circuit board guide and the conductors of the printed circuit board, with retention of the spring function, prevents corrosion formation between them. The electromagnetic shielding is consequently durable.

## Claims

1. Printed circuit board guide (1) suitable for fixing on a support (12), and comprising a pair of guide elements which define a guide space suitable for guiding therein, parallel to an edge of a printed circuit board (16), an edge part of the printed circuit board (16), **characterized in that** the guide elements are composed of resilient fingers (6, 7) which on either side of the guide space go out from a strip of material in a staggered in a direction parallel to bend lines (8, 9) of the fingers (6, 7) through an angle of bend less than 90°, the bend lines (8, 9) being situated perpendicular to a guide direction for the printed circuit board (16) and parallel to a main surface of the printed circuit board (16), and end parts of the fingers (6, 7) being bent back, in such a way that a minimum distance between the fingers on either side of the guide space, measured perpendicular to the printed circuit board (16), is less than the thickness of the printed circuit board (16).

2. Printed circuit board guide (1) according to claim 1, **characterized in that** the strip has at several locations in a direction perpendicular to the bend lines (8, 9) of the fingers and to the printed circuit board (16) a group of fingers (6, 7) with a respective guide space.

3. Printed circuit board guide (1) according to claim 1 or 2, **characterized in that** the strip being bent over an angle line (23) which is parallel to a direction perpendicular to the bend lines (8, 9) of the fingers (6, 7), so that the printed circuit board guide (1) is in the form of an angle section.

4. Method for producing a printed circuit board guide (1), comprising the steps of:
- pressing fingers (6, 7) out of a strip of resilient material along parallel first bend lines (8) through an angle of less than 90°, thereby forming a guide space between the fingers which is suitable for guiding therein a printed circuit board (16) in a direction perpendicular to the strip;
- at a distance from the first bend lines, bending away from each other end parts of the fingers (6, 7) on either side of the guide space along second bend lines (9) running parallel to the first bend lines (8); in such a way that a minimum distance between the fingers (6, 7) on either side of the guide space is less than the thickness of the printed circuit board (16).

5. Method according to claim 4, **characterized in that** a group of fingers (6, 7) with a respective guide space is formed at several locations in the strip in a direction perpendicular to the bend lines (8, 9).

6. Method according to claim 4 or 5, **characterized in that** after formation of the fingers (6, 7) the strip is bent through an angle along an angle line (23) situated perpendicular to the bend lines (8, 9).

## Patentansprüche

1. Leiterplattenführungseinrichtung (1), die an einem Halteelement (12) befestigbar ist und ein Paar von Führungselementen aufweist, die einen Führungsraum definieren, um in diesem parallel zu einer Kante einer Leiterplatte (16) einen Kantenteil der Leiterplatte (16) zu führen, **dadurch gekennzeichnet ist, dass** die Führungselemente aus elastischen Fingern (6, 7) gebildet sind, die sich auf jeder Seite des Führungsraumes aus einem Streifen eines Materials hinaus in einer Richtung parallel zu Biegelinien (8, 9) der Finger (6, 7) mit einem Biegewinkel von weniger als 90° erstrecken, wobei die Biegelinien (8, 9) senkrecht zu einer Führungsrichtung für die Leiterplatte (16) und parallel zu einer Hauptfläche der Leiterplatte (16) angeordnet sind, und Endteile der Finger (6, 7) derart zurück gebogen sind, dass ein minimaler Abstand zwischen den Fingern auf jeder Seite des Führungsraumes, senkrecht zu der Leiterplatte (16) gemessen, kleiner als die Dicke der Leiterplatte (16) ist.

2. Leiterplattenführungseinrichtung (1) nach Anspruch 1, **dadurch gekennzeichnet, dass** der Streifen an mehreren Positionen in einer Richtung senkrecht zu den Biegelinien (8, 9) der Finger und zur Leiterplatte (16) eine Gruppe von Fingern (6, 7) mit einem entsprechenden Führungsraum aufweist.

3. Leiterplatlenführungseinrichtung (1) nach Anspruch 1 oder 2, **dadurch gekennzeichnet, dass** der Streifen über eine Winkellinie (23) gebogen ist, die sich parallel zu einer Richtung senkrecht zu den Biegelinien (8, 9) der Finger (6, 7) erstreckt, so dass die Leiterplattenführungseinrichtung (1) die Form eines Winkelabschnittes aufweist.

4. Verfahren zum Herstellen einer Leiterplattenführungseinrichtung (1), das die Schritte aufweist:
- Pressen von Fingern (6, 7) aus einem Streifen eines elastischen Materials entlang paralleler erster Biegelinien (8) mit einem Winkel von weniger als 90°, so dass ein Führungsraum zwischen den Fingern ausgebildet wird, in dem eine Leiterplatte (16) in einer Richtung senkrecht zu dem Streifen führbar ist;
- Wegbiegen von Endteilen der Finger (6, 7) voneinander in einem Abstand von den ersten Biegelinien an jeder Seite des Führungsraums entlang zweiter Biegelinien (9), die sich parallel zu den ersten Biegelinien (8) erstrecken;
derart, dass ein minimaler Abstand zwischen den Fingern (6, 7) auf jeder Seite des Führungsraumes geringer als die Dicke der Leiterplatte (16) ist.

5. Verfahren nach Anspruch 4, **dadurch gekennzeichnet, dass** eine Gruppe von Fingern (6, 7) mit einem entsprechenden Führungsraum an mehreren Positionen in dem Streifen in einer Richtung senkrecht zu den Biegelinien (8, 9) ausgebildet wird.

6. Verfahren nach Anspruch 4 oder 5, **dadurch gekennzeichnet, dass** der Streifen nach dem Ausbilden der Finger (6, 7) um einen Winkel entlang einer Winkellinie (23), die senkrecht zu den Biegelinien (8, 9) angeordnet ist, gebogen wird.

## Revendications

1. Guide (1) pour carte de circuit imprimé adapté pour une fixation sur un support (12), et comprenant une paire d'éléments de guidage qui définissent un espace de guidage adapté pour le guidage à l'intérieur, parallèle à un bord d'une carte de circuit imprimé (16), d'une partie du bord de la carte imprimé (16), **caractérisé en ce que** les éléments de guidage sont composés de doigts élastiques (6, 7) qui sur chaque côté de l'espace de guidage se dirigent vers l'extérieur à partir d'une barrette de matériau dans une direction parallèle à des lignes de courbure (8 , 9) des doigts (6, 7) avec un angle de courbure inférieur à 90°, les lignes de courbure (8, 9) étant situées de manière perpendiculaire à une direction de guidage pour la carte de circuit imprimé (16) et parallèle à une surface principale de la carte de circuit imprimé (16), et des parties d'extrémité des doigts (6, 7) étant repliées, de telle manière qu'une distance minimum entre les doigts sur chaque côté de l'espace de guidage, mesurée perpendiculairement à la carte de circuit imprimé (16), est inférieur à l'épaisseur de la carte de circuit imprimé (16).

2. Guide (1) pour carte de circuit imprimé selon la revendication 1, **caractérisé en ce que** la barrette a, à plusieurs emplacements dans une direction perpendiculaire aux lignes de courbures (8, 9) des doigts et à la carte de circuit imprimé (16), un groupe de doigts (6, 7) avec un espace de guidage respectif.

3. Guide (1) pour carte de circuit imprimé selon l'une des revendications 1 ou 2, **caractérisé en ce que** la barrette est courbée par-dessus une ligne d'angle (23) qui est parallèle à une direction perpendiculaire aux lignes de courbure (8, 9) des doigts (6, 7), de sorte que le guide (1) pour la carte de circuit imprimé a la forme d'une section angulaire.

4. Procédé pour la production d'un guide (1) pour carte de circuit imprimé comprenant les étapes suivantes :
- presser des doigts (6, 7) hors d'une barrette de matériau élastique le long de premières lignes de courbures parallèles (8) avec un angle de moins de 90°, formant ainsi un espace de guidage entre les doigts qui est adapté pour guider une carte de circuit imprimé (16) dans l'espace de guidage selon une direction perpendiculaire à la barrette ;
- à une distance des premières lignes de courbures, courber les parties d'extrémités des doigts (6, 7) en les éloignant les unes par rapport aux autres sur chaque côté de l'espace de guidage le long de deuxième lignes de courbures (9) dirigées manière parallèle aux premières lignes de courbures (8);
de telle façon qu'une distance minimum entre les doigts (6, 7) sur chaque côté de l'espace de guidage est inférieur à l'épaisseur de la carte de circuit imprimé (16).

5. Procédé selon la revendication 4, **caractérisé en ce qu'**un groupe de doigts (6, 7) avec un espace de guidage respectif est formé à plusieurs emplacements dans la barrette dans une direction perpendiculaire aux lignes de courbures (8, 9).

6. Procédé selon la revendication 4 ou 5, **caractérisé en ce qu'**après la formation des doigts (6, 7) la barrette est courbée selon un angle le long d'une ligne d'angle (23) située perpendiculairement aux lignes de courbures (8, 9).
